(19) Europäisches Patentamt
European Patent Office
Office européen des brevets

(11) EP 2 439 663 A1

(12) EUROPEAN PATENT APPLICATION

(43) Date of publication:
11.04.2012 Bulletin 2012/15

(51) Int Cl.:
$G06F\ 17/50$ $^{(2006.01)}$

(21) Application number: 10178383.5

(22) Date of filing: 22.09.2010

(84) Designated Contracting States:
AL AT BE BG CH CY CZ DE DK EE ES FI FR GB GR HR HU IE IS IT LI LT LU LV MC MK MT NL NO PL PT RO SE SI SK SM TR
Designated Extension States:
BA ME RS

(71) Applicant: Siemens Aktiengesellschaft
80333 München (DE)

(72) Inventors:
• Barti, Endre
80689 München (DE)
• Wever, Utz
81539 München (DE)

(54) **A method, apparatus and computer program product for the finite element analysis of frequency dependent behaviour of nonlinear materials and contacts**

(57) The present invention relates to an analysis method, apparatus and computer software for the analysis for the frequency behaviour of assemblies containing nonlinear materials, and contacts between a plurality of components comprised in the assemblies. In accordance to the present invention, the frequency behaviour of assemblies containing nonlinear materials, and contacts between a plurality of components comprised in the assemblies is analysed by dividing a volume and a contact area of the assemblies into a plurality of finite elements characterized by a plurality of frequency and displacement dependent matrices, linearizing an equation characteristic for the frequency behaviour of the assemblies, solving the characteristic equation in a frequency domain, performing a first stage projection in a time domain to reduce a number of degrees of freedom of said plurality of finite elements from a number of said plurality of finite elements to a number of relevant modes, performing a second stage projection in the frequency domain, and calculating a plurality of Fourier series coefficients describing the frequency behaviour of the assemblies.

FIG 1

**Description**

FIELD OF THE INVENTION

The present invention relates generally to the field of materials analysis, and more particularly to an analysis method, apparatus and computer program product for studying the frequency dependent behaviour of systems with nonlinear material properties and contact problems, the method and computer software being practiced via an analysis apparatus.

BACKGROUND OF THE INVENTION

Todays modern devices, for example in the field of medical devices, are assemblies with a high number of components. At the interface between these components that is called contact face or contact areas, to a large degree nonlinear materials are used.

In mechanical engineering, finite element analysis is a common choice, both for metals and non-metals. If for example it might be of interest to estimate the expected lifetime of a polypropylene-made bracket supporting a box in a car, it is of note that the load applied onto the bracket is clearly cyclic, following the vibration of the chassis. Thus, phenomena to be taken into account when studying its behaviour, include mechanical dissipation, temperature dependency and heat, probably as well, generated by dissipation. Furthermore, since the box is relatively heavy, large strains are also expected. Consequently, a complete analysis of the behaviour of the bracket should include both the finite element model and the investigation of the material law.

The behaviour of the bracket is non-linear. More precisely, among the sources of non-linearity are: the large displacements that are expected, possibly large strains, the material behaviour and contacts between different components. One of the goals is to determine the 'eigenfrequencies' of the system. In order to do so, two procedures may be applied: Linear eigenfrequency calculation that is a fast and efficient way to determine the eigenfrequencies that are interesting from an engineering point of view. Furthermore, it also provides information about vibration modes (eigenvectors). However, it does/cannot take into account non-linear effects such as large displacements, non-linear material behaviour and contacts. The second procedure is time integration. Time integration is a very general way to find the time history of a certain physical quantity for example the acceleration in some interesting points. These data can then be processed similarly to measurement data. The main drawback of this method is the huge computational effort that it requires.

Therefore, a need still exists for reducing the amount of time necessary, and resources employed during the testing and study of devices comprising contacts between various components with nonlinear materials properties (e.g. deformation and frequency dependency), such as elastomers and polymers or all plastic deformed metals.

Usually the amount of time and resources necessary has been proposed to be reduced by performing exclusively computer simulation of the devices to be built and attempting to develop and test all the constructional details of the device intended to be realized, via computer simulation. As such the need for building and testing actual prototypes is reduced to minimum.

The virtual testing of the devices with multiple contacts between nonlinear materials poses a plurality of other problems such as is very difficult to accurately reproduce the behaviour of materials that are frequency dependent, and to reproduce the behaviour of contact regions between components, especially if one has to take into account the damping effect of contacts by using physically correct coefficients of friction.

Regarding these contact regions and materials a modal, or a harmonic analysis is not applicable. What further complicates the analysis is the fact that the damping of the materials and contact faces comprised in the assembly depends no longer only on the frequency but also on the displacement, or the movement of said contacts. Currently is only possible to make, via commercial simulation tools, a linear analysis of the structural mechanics for the materials comprised in the interface (contact). Said simulation tools do not work well for materials and systems with a plurality of interfaces between various nonlinear material properties. Further, the simulation tools currently available do not allow simulating the dynamical behaviour of nonlinear materials in the frequency domain or the dynamical behaviour of assemblies comprising nonlinear materials, especially in a frequency range from 1 to 30,000 Hz.

Therefore, a need still exists for a simulation method capable of performing accurate simulation in the frequency domain of the behaviour of contacts or interfaces comprising nonlinear materials. The need also exists for a simulation method that provides an accurate periodic simulation in the frequency domain of the behaviour of contacts or interfaces comprising nonlinear materials. Further, a need still exists for an apparatus that permits the accurate dynamical simulation of the behaviour of contacts or interfaces between nonlinear materials.

SUMMARY OF THE INVENTION

The present invention provides a solution to the above problems by providing the method of analysis for the frequency behaviour of assemblies containing nonlinear materials, and contacts between a plurality of components comprised in the assemblies of claim 1, the system of claim 8, and the computer program product of claim 10.

In accordance with an embodiment of the present invention it is envisioned a method of analysis for the frequency behaviour of assemblies containing nonlinear materials, and contacts between a plurality of components comprised in the assemblies. The method comprises at least dividing a volume and a contact area of the assemblies into a plurality of finite elements characterized by a plurality of frequency and displacement dependent matrices, linearizing an equation characteristic for the frequency behaviour of the assemblies, solving said characteristic equation in a frequency domain, performing a first stage projection in a time domain to reduce a number of degrees of freedom of said plurality of finite elements from a number of said plurality of finite elements to a number of relevant mode, performing a second stage projection in the frequency domain, and calculating a plurality of Fourier series coefficients describing the frequency behaviour of the assemblies.

In accordance with another embodiment of the present invention it is envisioned a system comprising a data bus system, a memory coupled to the data bus system, wherein the memory includes computer usable program code, a processing unit coupled to the data bus system, wherein the processing unit executes the computer usable program code to divide a volume and a contact area of the assemblies into a plurality of finite elements characterized by a plurality of frequency and displacement dependent matrices, linearize an equation characteristic for the frequency behaviour of the assemblies, solve the characteristic equation in a frequency domain, perform a first stage projection in a time domain to reduce a number of degrees of freedom of said plurality of finite elements from a number of said plurality of finite elements to a number of relevant modes, perform a second stage projection in the frequency domain, and calculate a plurality of Fourier series coefficients describing the frequency behaviour of the assemblies.

In accordance with a further embodiment of the present invention it is envisioned computer program product comprising a tangible computer usable medium including computer usable program code for performing diagnosis detection in a system, the computer usable program code for dividing a volume and a contact area of the assemblies into a plurality of finite elements characterized by a plurality of frequency and displacement dependent matrices, linearizing an equation characteristic for the frequency behaviour of the assemblies; solving said characteristic equation in a frequency domain, performing a first stage projection in a time domain to reduce a number of degrees of freedom of staid plurality of finite elements from a number of said plurality of finite elements to a number of relevant modes; performing a second stage projection in the frequency domain, and calculating a plurality of Fourier series coefficients describing the frequency behaviour of the assemblies.

Compared to other solutions offered in the art, the solution provided by the present invention offers the possibility to reduce the number of equations in the nonlinear system characteristic, reducing therefore the computing time and effort necessary to fully characterize the nonlinear behaviour of said assembly.

Particularly advantageous embodiments and features of the invention are given by the dependent claims, as revealed in the following description.

The method of the present invention further comprises stating an equation characteristic for the behaviour of the assembly. A solution to said characteristic equation is displacement. The frequency behaviour of the assembly is periodic and nonlinear. By dividing the assembly volume and a contact area into a plurality of finite elements characterized by a plurality of frequency and displacement dependent matrices discretization. For solving the characteristic equation, the equation is projected onto a plurality of modes obtained from linear analysis, in a time domain. The method is employed for simulating the dynamical behaviour of parts and assemblies containing frequency and displacement dependent materials. The memory integrated in the system propose by the present invention stores a Finite element (FEM) software.

BRIEF DESCRIPTION OF THE DRAWINGS

Other objects and features of the present invention will become apparent from the following detailed descriptions considered in conjunction with the accompanying drawings. It is to be understood, however, that the drawings are designed solely for the purposes of illustration and not as a definition of the limits of the invention.

Fig. 1 is a representation of a flow chart of the method proposed by the present invention;

Fig. 2 represents an embodiment of a data processing system in which an application for the analysis of assembly behaviour may be implemented.

Non-limiting and non-exhaustive embodiments of the present invention are described with reference to the above referenced figures, wherein like reference numerals refer to like parts throughout the various views unless otherwise specified. The order of description should not be construed as to imply that these operations are necessarily order-dependent.

DETAILED DESCRIPTION OF THE INVENTION

As will be appreciated by one skilled in the art, the present disclosure may be embodied as a model, method, system or computer program product. Accordingly, the present disclosure may take the form of an entirely hardware embodiment, an entirely software embodiment (including firmware, resident software, micro-code, etc.) or an embodiment combining software and hardware aspects that may all generally be referred to herein as a "circuit," "module" or "system."

The present disclosure is described below with reference to flowchart illustrations and/or block diagrams of methods, apparatus (systems) and computer program products according to embodiments of the disclosure. It will be understood that each block of the flowchart illustrations and/or block diagrams, and combinations of blocks in the flowchart illustrations and/or block diagrams, can be implemented by computer program instructions. These computer program instructions may be provide to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer-readable medium that can direct a computer or other programmable data processing apparatus to function in a particular manner, such that the instructions stored in the computer-readable medium produce an article of manufacture including instruction means which implement the function/act specified in the flowchart and/or block diagram block or blocks.

The computer program instructions may also be loaded onto a computer or other programmable data processing apparatus to cause a series of operational steps to be performed on the computer or other programmable apparatus to produce a computer implemented process such that the instructions which execute on the computer or other programmable apparatus provide processes for implementing the functions/acts specified in the flowchart and/or block diagram block or blocks.

The materials such as polymers and rubbers are special materials since their characteristics are not constant but are frequency dependent. Examples of such variables are the Young's modulus (E), the Poisson's ratio and the loss factor.

While studying the behaviour of devices constructed from nonlinear materials at least the oscillation, movement, and vibration of the materials is studied. While studying the behaviour at the level of interfaces/contacts comprising materials with nonlinear behaviour, in the art are known attempts to study said behaviours via an equation such as:

$$M\ddot{u}(t) + C(u)\dot{u}(t) + K(u)u(t) = F(t) \tag{1}$$

Where :

M is the mass matrix;
ü(t) is the second derivative, acceleration, indicative of the displacement of the material or indicative of how the material oscillates/moves;
C(u) is the damping matrix;
u̇(t) is the first derivative, velocity;
K(u) is the stiffness matrix;
u(t) is the function describing the displacement,
t is time, and
F(t) is indicative of the load, external excitation, vibration, etc.

In the art the above equation is attempted to be solved in the time domain, via numerical time integration. Obtaining a solution to the above equation in the time domain is a lengthy and a time consuming process. Further, the solution process consumes a large computing power.

In the art the equation has also been attempted to be solved via the Harmonic balance method that is suitable to solving nonlinear periodic problems. A solution to this approach is:

$$u(t,x) = \frac{a_0(x)}{2} + \sum_{l=1}^{n}\left(a_l(x)\cos(l\omega t) + b_l(x)\sin(l\omega t)\right) , \qquad (2)$$

With $a_0(x),.....,a_n(x),b_1(x),.....b_n(x)$ being defined for each node of the finite element model applicable to the system studied.

Unfortunately when attempting to solve the problem in the frequency domain by normal harmonic balance, a very large system of nonlinear equations is generated. Due to the number of resulting equations the system of equations can be hardly stored on a computer and the solving time of the system is very high. If N is the number of nodes and n is the total number of degrees of freedom, the resulting system of nonlinear equations has the dimension of N x n.

The present invention proposes a solution to equations such as (1) that is a nonlinear equation with an external force, solution that is obtained via an algorithm in the frequency domain.

In accordance with the present invention, in order to solve the equation 1 the Galerkin approach is used that involves methods for converting a continuous operator problem (such as a differential equation) to a discrete problem. As a result, the number of coefficients is greatly reduced and the resulting equations may be solved via, for example, the Newton's method.

Therefore, in accordance with the present invention, the equation 1 is first linearized for the autonomous case, and the linearized equation is attempted two be solved in the absence of the external excitation, with F(t) = 0.

Therefore, for the linearized autonomous case the equation 1 will be:

$$M\ddot{u}(t) + C(u_0)\dot{u}(t) + K(u_0)u(t) = 0 , \qquad (3)$$

therein $U_0$ is a constant.

While solving the equation 3, a common mode analysis is performed, and the equation 3 is solved to find the eigenvalue of the system. This equation may be solved only for the linearized system.

The corresponding modes and frequencies of equation 3, are $(\Phi_k,\omega_k)$, where k=1...m, are solutions of the quadratic eigenvalue problem, m representing the number of relevant modes and the $\Phi$ is the eigenvector that covers all finite element nodes.

$(\Phi_k,\omega_k)$ are solutions to the quadratic eigenvalue problem:

$$\left[M\omega^2 + C(u_0)i\omega + K(u_0)\right]\Phi = 0 \qquad (4)$$

Therefore, the solution to the nonlinear problem expressed via equation 1 may be expressed as

$$u(x,t) = \sum_{k=1}^{m} c_k(t)\Phi_k(x) \qquad (5)$$

Where $C_k(t)$ is a time dependent scalar,

u(x, t) is indicative of the solution, a large vector that in finite element analysis corresponds to hundred of thousand of nodes. m has much lower dimensions, and corresponds to the actual number of relevant modes.

Presenting the equation in the format 5 above has the consequence of reducing the number of degrees of freedom involved in the analysis.

For the next step, the analysis method proposed by the present invention proposes the introduction of solution 5 in equation 6 below and the projection of the eigenvector.

Specifically, the equation 6 is

$$M\ddot{u}(t) + C(u)\dot{u}(t) + K(u)u(t) = F(t) \tag{6}$$

Equation 6 is a fully nonlinear equation that is attempted to be solved in the frequency domain.

Inserting the solution 5 into equation 6 and projecting the equation onto the mode shapes leads to the following equation:

$$\sum_{k=1}^{m} \ddot{c}_k(t)\langle M\Phi_k(x), \Phi_j(x)\rangle +$$

$$+ \sum_{k=1}^{m} \dot{c}_k(t)\left\langle C\left(\sum_{i=1}^{m} c_i(t)\Phi_i(x)\right)\Phi_k(x), \Phi_j(x)\right\rangle + \tag{7}$$

$$+ \sum_{k=1}^{m} c_k(t)\left\langle K\left(\sum_{i=1}^{m} c_i(t)\Phi_i(x)\right)\Phi_k(x), \Phi_j(x)\right\rangle = \langle F(t), \Phi_j(x)\rangle, j = 1,...,m$$

The projection takes place via the scalar product:

$$\langle f(x), g(x)\rangle = \int_{\Omega} f(x)g(x)dx \tag{8}$$

The following abbreviations are made:

$\hat{M} = (M\Phi_k(x), \Phi_j(x))$, wherein $\hat{M}$ is the projected mass matrix,

$$\hat{C}(c) = \left\langle C\left(\sum_{i=1}^{m} c_i(t)\Phi_i(x)\right)\Phi_k(x), \Phi_j(x)\right\rangle,$$

wherein $\hat{C}$ is the projected damping matrix,

$$\hat{K}(c) = \left\langle K\left(\sum_{i=1}^{m} c_i(t)\Phi_i(x)\right)\Phi_k(x), \Phi_j(x)\right\rangle,$$

wherein $\hat{K}$ is the projected stiffness matrix, and
$\hat{F}(t) = (F(t), \Phi_j(x))$, wherein $\hat{F}$ is the projected load from outside.

In the above abbreviations, m is indicative of the number of important modes.
With the abbreviations made above, equation 7 reads:

$$\hat{M}\ddot{c}(t) + \hat{C}(c)\dot{c}(t) + \hat{K}(c)c(t) = \hat{F}(t) \tag{8}$$

The projected equation 8 may be solved via the Harmonic Balance method and as such each coefficient $C_k(t)$ may be expressed as a Fourier expansion:

$$c_k(t) = \frac{a_k^0}{2} + \sum_{l=1}^{n}\left(a_k^l\cos(l\omega t) + b_k^l\sin(l\omega t)\right)$$

With $a_0, ..., a_n$, and $b_1, ..., b_n \in R$

As a result of the projection, there are only m sets of parameters $a_0, ..., a_n$, and $b_1, ..., b_n$ instead for each degree of freedom.

With

$$f(\ddot{c}(t), \dot{c}(t), c(t)) = \hat{M}\ddot{c}(t) + \hat{C}(c)\dot{c}(t) + \hat{K}(c)c(t) - \hat{F}(t)$$

The equation of harmonic balance is:

$$p_k = \omega\int_0^{\frac{2\pi}{\omega}} f(\ddot{c}(t), \dot{c}(t), c(t))\cos(\omega k t)dt = 0, \qquad k=0, ..., n$$

$$q_k = \omega\int_0^{\frac{2\pi}{\omega}} f(\ddot{c}(t), \dot{c}(t), c(t))\sin(\omega k t)dt = 0, \qquad k=1, ..., n$$

Therefore, the total solution of the method if given by:

$$u(x,t) = \sum_{k=1}^{m}\left(\frac{a_k^0}{2} + \sum_{l=1}^{n}\left(a_k^l\cos(l\omega t) + b_k^l\sin(l\omega t)\right)\right)\Phi_k(x),$$

wherein the brackets on the right side of the equation corresponds to $C_k$.

In the above expression by n is understood the number of Fourier terms, $a_k^l$ and $b_k^l$ are the constant rate for each harmonic, k is the number of modes, and 1 is the number of Fourier expansions.

The solution is indicative of displacement of every node in the system that is studied. The knowledge regarding the displacement permits therefore the calculation of other characteristics of the system, such as the stress.

As a result of expressing $C_k$ as a Fourier function, and making a projection, a solution is obtained not for c but for the network of a and b coefficients.

The a and b coefficients of the Fourier expansion are placed back in $C_k$ and back in the expression of u. As such the total solution of equations 1 is obtained via a two staged projection.

Therefore to summarize, in accordance with to the present invention, is proposed a method for the analysis of assemblies with frequency and displacement dependent materials that involves a two stage projection. Via the first projection, the number of degrees of freedom are reduced in the time domain. Subsequent to the first projection, a second projection is performed, into the frequency domain that permits carrying over the characteristic system of equations from the time domain to the frequency domain. Subsequently, the projected matrices $\hat{M}, \hat{C}, \hat{K}, \hat{F}$ and therefore the Fourier coefficients may be calculated in the finite element analysis via any method customarily utilized in the finite element analysis, such as the Newton method. Therefore, a complete characterization of the system is possible, via its mass, damping, stiffness and load applied from outside the system. Since the method involves a reduced number of calculations in the frequency domain, the necessary computation time and computational power is significantly reduced versus other methods proposed in the art.

The analysis described above is employed for simulating the dynamical behaviour of assemblies comprising frequency and displacement dependent materials. The method saves a huge amount of execution time compared with the state of the art methods.

In all of the above it may be exemplarily assumed that a frequency dependant material is a polymer and a rubber and an interface is formed between different parts of an assembly. The plurality of variables characteristic for the frequency dependent materials comprises at least one of Young's modulus (E), Poisson's ratio and loss factor.

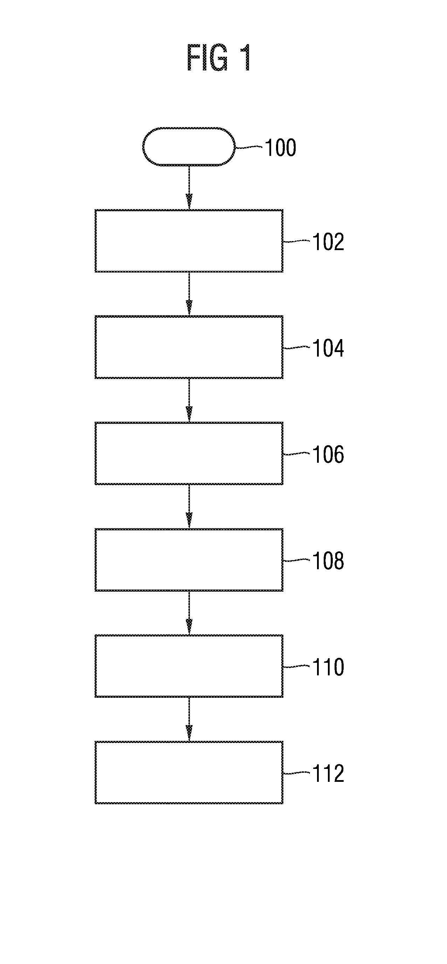

Referring now to Figure 1, Figure 1 is a representation of a flow chart of the method 100 of analysis for the frequency behaviour of assemblies containing nonlinear materials, and contacts between a plurality of components comprised in the assemblies, as proposed by the present invention.

The method 100 of analysis for the frequency behaviour of assemblies containing non-linear materials, and contacts between a plurality of components comprised in the assemblies of figure 1 comprises at least the steps of dividing 102 a volume and a contact area of the assemblies into a plurality of finite elements characterized by a plurality of frequency and displacement dependent matrices, linearizing 104 an equation characteristic for the frequency behaviour of the assemblies, solving 106 the characteristic equation in a frequency domain, performing 108 a first stage projection in a time domain to reduce a number of degrees of freedom of the plurality of finite elements from a number of said plurality of finite elements to a number of relevant modes, performing 110 a second stage projection in the frequency domain, and calculating 112 a plurality of Fourier series coefficients describing the frequency behaviour of the assemblies.

The analysis method described in detail above in connection with FIG. 1 is used for and in simulating the dynamic behaviour of assemblies comprising frequency dependent materials, general nonlinear materials and interfaces between parts.

The method further comprises stating the equation characteristic for the frequency behaviour of the assemblies. A solution to the characteristic equation is displacement. The frequency behaviour of the assemblies is periodic and nonlinear. By dividing the assembly volume and a contact area into a plurality of finite elements characterized by a plurality of frequency and displacement dependent matrices discretization of the assembly volume and contact area is obtained, the behaviour of each discrete element being characterized at least by the number of Fourier coefficients. For solving said characteristic equation the equation is projected onto a plurality of relevant modes obtained from linear analysis, in the time domain. The method is employed for simulating the dynamic behaviour of parts and assemblies containing frequency dependent materials, general nonlinear materials and interfaces between parts.

The present invention may also take the form of a system comprising at least a data bus system, memory coupled to the data bus system, wherein the memory includes computer usable program code, a processing unit coupled to the data bus system, wherein the processing unit executes the computer usable program code to divide a volume and a contact area of the assemblies into a plurality of finite elements characterized by a plurality of frequency and displacement dependent matrices, linearize an equation characteristic for the frequency behaviour of the assemblies, solving said characteristic equation in a frequency domain, perform a first stage projection in a time domain to reduce a number of degrees of freedom of said plurality of finite elements from a number of said plurality of finite elements to a number of relevant modes, perform a second stage projection in the frequency domain, and calculate a plurality of Fourier series coefficients describing the frequency behaviour of the assemblies.

Furthermore, the present disclosure may take the form of a computer program product embodied in any tangible medium of expression having computer-usable program code embodied in the medium.

Any combination of one or more computer usable or computer readable medium(s) may be utilized. The computer-usable or computer-readable medium may be, for example but not limited to, an electronic, magnetic, optical, electromagnetic, infrared, or semiconductor system, apparatus, device, or propagation medium. More specific examples (a non-exhaustive list) of the computer-readable medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a transmission media such as those supporting the Internet or an intranet, or a magnetic storage device. Note that the computer-usable or computer-readable medium could even be paper or another suitable medium upon which the program is printed, as the program can be electronically captured, via, for instance, optical scanning of the paper or other medium, then compiled, interpreted, or otherwise processed in a suitable manner, if necessary, and then stored in a computer memory. In the context of this document, a computer-usable or computer-readable medium may be any medium that can contain, store, communicate, propagate, or transport the program for use by or in connection with the instruction execution system, apparatus, or device. The computer-usable medium may include a propagated data signal with the computer-usable program code embodied therewith, either in baseband or as part of a carrier wave. The computer usable program code may be transmitted using any appropriate medium, including but not limited to wireless, wireline, optical fiber cable, RF, etc.

Computer program code for carrying out operations of the present disclosure may be written in any combination of one or more programming languages, including an object oriented programming language such as Java, Smalltalk, C++ or the like and conventional procedural programming languages, such as the "C" programming language or similar programming languages. The program code may execute entirely on the user's computer, partly on the user's computer, as a stand- alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

A computer program product in accordance with the present invention comprises a tangible computer usable medium including computer usable program code for performing a method for the frequency behaviour of assemblies containing nonlinear materials, and contacts between a plurality of components comprised in the assemblies, the computer usable program code for dividing a volume and a contact area of the assemblies into a plurality of finite elements characterized by a plurality of frequency and displacement dependent matrices, linearizing an equation characteristic for the frequency behaviour of the assemblies, solving said characteristic equation in a frequency domain, performing a first stage projection in a time domain to reduce a number of degrees of freedom of said plurality of finite elements from a number of said plurality of finite elements to a number of relevant modes, performing a second stage projection in the frequency domain, and calculating a plurality of Fourier series coefficients describing the frequency behaviour of the assemblies.

A computer program product that executes the method for analysis regarding the frequency behaviour of assemblies containing nonlinear materials, and contacts between a plurality of components comprised in the assemblies in a system of the present invention, resides in an embedded hardware module in the studied devices. Alternatively, the computer program product may reside on a microcontroler, in a pre-compiled form to be used at the diagnostic /intervention site. Alternatively, the computer program product may reside on a central computer that may host all expert knowledge or be a combination of embedded at the site, and a central server.

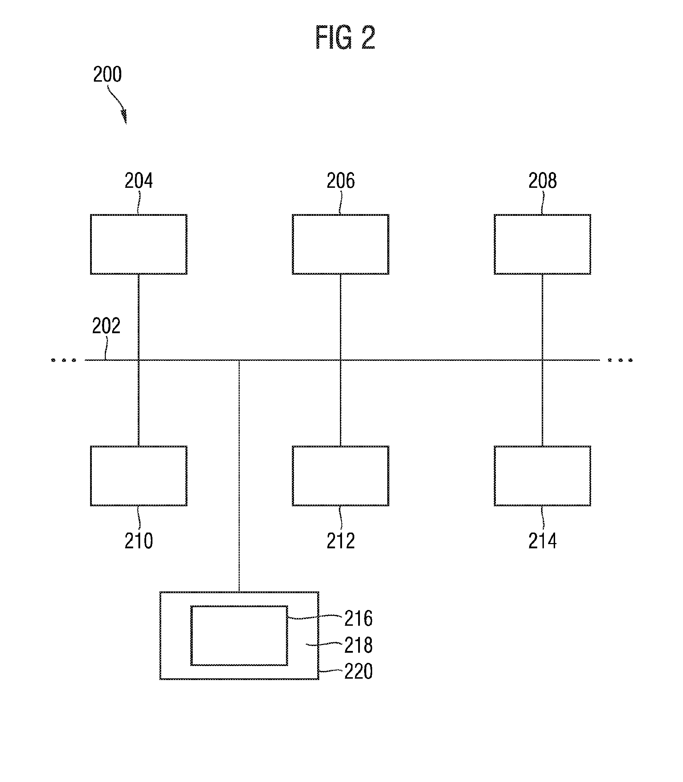

FIG. 2 is an embodiment of a data processing system 200 in which an embodiment of a system in accordance with the present invention may be implemented. The data processing system of FIG. 2 may be located and/or otherwise operate at any node of a computer network, that may exemplarily comprise clients 210 and/or 220, servers 240 and/or 250, etc. In the embodiment illustrated in FIG. 2, data processing system 200 includes communications fabric 202, which provides communications between processor unit 204, memory 206, persistent storage 208, communications unit 210, input/output (I/O) unit 212, and display 214.

Processor unit 204 serves to execute instructions for software that may be loaded into memory 206. Processor unit 204 may be a set of one or more processors or may be a multi-processor core, depending on the particular implementation. Further, processor unit 204 may be implemented using one or more heterogeneous processor systems in which a main processor is present with secondary processors on a single chip. As another illustrative example, processor unit 204 may be a symmetric multi-processor system containing multiple processors of the same type.

In some embodiments, memory 206 may be a random access memory or any other suitable volatile or non-volatile storage device. Persistent storage 208 may take various forms depending on the particular implementation. For example, persistent storage 208 may contain one or more components or devices. Persistent storage 208 may be a hard drive, a flash memory, a rewritable optical disk, a rewritable magnetic tape, or some combination of the above. The media used by persistent storage 208 also may be removable such as, but not limited to, a removable hard drive.

Communication unit 210 provides for communications with other data processing systems or devices. In these examples, communications unit 210 is a network interface card. Modems, cable modem and Ethernet cards are just a few of the currently available types of network interface adapters. Communications unit 210 may provide communications through the use of either or both physical and wireless communications links.

Input/output unit 212 enables input and output of data with other devices that may be connected to data processing system 200. In some embodiments, input/output unit 212 may provide a connection for user input through a keyboard and mouse. Further, input/output unit 212 may send output to a printer. Display 214 provides a mechanism to display information to a user.

Instructions for the operating system and applications or programs are located on persistent storage 208. These instructions may be loaded intro memory 206 for execution by processor unit 204. The processes of the different embodiments may be performed by processor unit 204 using computer implemented instructions, which may be located in a memory, such as memory 206. These instructions are referred to as program code, computer usable program code, or computer readable program code that may be read and executed by a processor in processor unit 204. The program code in the different embodiments may be embodied on different physical or tangible computer readable media, such as memory 206 or persistent storage 208.

A program code 216 is located in a functional form on a computer readable media 218 that is selectively removable and may be loaded onto or transferred to data processing system 200 for execution by processor unit 204. Program code 216 and computer readable media 218 form computer program product 220 in these examples. In one example, computer readable media 218 may be in a tangible form, such as, for example, an optical or magnetic disc that is inserted or placed into a drive or other device that is part of persistent storage 208 for transfer onto a storage device, such as a hard drive that is part of persistent storage 208. In a tangible form, computer readable media 218 also may take the form of a persistent storage, such as a hard drive, a thumb drive, or a flash memory that is connected to data processing system 200. The tangible form of computer readable media 218 is also referred to as computer recordable storage media. In some instances, computer readable media 218 may not be removable.

Alternatively, program code 216 may be transferred to data processing system 200 from computer readable media 218 through a communications link to communications unit 210 and/or through a connection to input/output unit 212. The communications link and/or the connection may be physical or wireless in the illustrative examples. The computer readable media also may take the form of non-tangible media, such as communications links or wireless transmissions containing the program code.

The different components illustrated for data processing system 200 are not meant to provide architectural limitations to the manner in which different embodiments may be implemented. The different illustrative embodiments may be implemented in a data processing system including components in addition to or in place of those illustrated for data processing system 200. Other components shown in FIG. 2 can be varied from the illustrative examples shown. For example, a storage device in data processing system 200 is any hardware apparatus that may store data. Memory 206, persistent storage 208, and computer readable media 218 are examples of storage devices in a tangible form.

Accordingly, the disclosed embodiments present a model, method and computer program product for the analysis of frequency behaviour of assemblies containing nonlinear materials, and contacts between a plurality of components comprised in the assemblies. The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description, but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In addition, the flowchart and block diagrams in the Figures illustrate the architecture, functionality, and operation of possible implementations of systems, methods and computer program products according to various embodiments of the present disclosure. In this regard, each block in the flowchart or block diagrams may represent a module, segment, or portion of code, which comprises one or more executable instructions for implementing the specified logical function (s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware- based systems that perform the specified functions or acts, or combinations of special purpose hardware and computer instructions.

**Claims**

1. A method of analysis for the frequency behaviour of assemblies containing nonlinear materials, and contacts between a plurality of components comprised in the assemblies, the method comprising:

dividing a volume and a contact area of the assemblies into a plurality of finite elements **characterized by** a plurality of frequency and displacement dependent matrices;
linearizing an equation characteristic for the frequency behaviour of the assemblies;
solving said characteristic equation in a frequency domain;
performing a first stage projection in a time domain to reduce a number of degrees of freedom of said plurality of finite elements from a number of said plurality of finite elements to a number of relevant modes;

performing a second stage projection in the frequency domain, and
calculating a plurality of Fourier series coefficients describing the frequency behaviour of the assemblies.

2. The method of claim 1, further comprising stating the equation characteristic for the frequency behaviour of the assemblies.

3. The method of claim 1 and 2, wherein a solution to said characteristic equation is displacement.

4. The method of claim 1, wherein the frequency behaviour of the assemblies is periodic and nonlinear.

5. The method of claim 1, wherein by dividing the assembly volume and a contact area into a plurality of finite elements **characterized by** a plurality of frequency and displacement dependent matrices discretization of the assembly volume and contact area is obtained, the behaviour of each discrete element being characterized at least by the number of Fourier coefficients.

6. The method of claim 1, wherein for solving said characteristic equation the equation is projected onto a plurality of relevant modes obtained from linear analysis, in the time domain.

7. The method of claim 1, wherein said method is employed for simulating the dynamic behaviour of parts and assemblies containing frequency dependent materials, general nonlinear materials and interfaces between parts.

8. A system comprising:

a data bus system;
memory coupled to the data bus system,
wherein the memory includes computer usable program code;
a processing unit coupled to the data bus system,
wherein the processing unit executes the computer usable program code to:

divide a volume and a contact area of the assemblies into a plurality of finite elements **characterized by** a plurality of frequency and displacement dependent matrices;
linearize an equation characteristic for the frequency behaviour of the assemblies;
solving said characteristic equation in a frequency domain;
perform a first stage projection in a time domain to reduce a number of degrees of freedom of said plurality of finite elements from a number of said plurality of finite elements to a number of relevant modes;
perform a second stage projection in the frequency domain, and
calculate a plurality of Fourier series coefficients describing the frequency behaviour of the assemblies.

9. The system of claim 8, wherein said memory stores a Finite element (FEM) software.

10. A computer program product comprising:

a tangible computer usable medium including computer usable program code for performing a method of analysis for the frequency behaviour of assemblies containing nonlinear materials and contacts between a plurality of components comprised in the assemblies, the computer usable program code for :

dividing a volume and a contact area of the assemblies into a plurality of finite elements **characterized by** a plurality of frequency and displacement dependent matrices;
linearizing an equation characteristic for the frequency behaviour of the assemblies;
solving said characteristic equation in a frequency domain;
performing a first stage projection in a time domain to reduce a number of degrees of freedom of said plurality of finite elements from a number of said plurality of finite elements to a number of relevant modes;
performing a second stage projection in the frequency domain, and
calculating a plurality of Fourier series coefficients describing the frequency behaviour of the assemblies.

# FIG 1

# FIG 2

Europäisches
Patentamt
European
Patent Office
Office européen
des brevets

# EUROPEAN SEARCH REPORT

Application Number

EP 10 17 8383

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Singiresu S. Rao: "The Finite Element Method in Engineering, Fourth Edition", 31 December 2005 (2005-12-31), Elsevier Butterworth-Heinemann, XP002631801, ISBN: 0-7506-7828-3 pages 421-457, * the whole document * ----- | 1-10 | INV. G06F17/50 |

TECHNICAL FIELDS SEARCHED (IPC)

G06F

The present search report has been drawn up for all claims

| Place of search | Date of completion of the search | Examiner |
|---|---|---|
| Munich | 7 April 2011 | Lerbinger, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)